(19) **Europäisches Patentamt**
**European Patent Office**
**Office européen des brevets**

(11) **EP 2 009 968 A1**

(12) **EUROPEAN PATENT APPLICATION**
published in accordance with Art. 153(4) EPC

(43) Date of publication:
**31.12.2008 Bulletin 2009/01**

(51) Int Cl.:
**H05K 1/02** (2006.01)      **H05K 7/20** (2006.01)

(21) Application number: **08720606.6**

(22) Date of filing: **26.03.2008**

(86) International application number:
**PCT/JP2008/000727**

(87) International publication number:
**WO 2008/129831 (30.10.2008 Gazette 2008/44)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **30.03.2007 JP 2007093238
10.04.2007 JP 2007102425**

(71) Applicant: **Panasonic Corporation
Kadoma-shi
Osaka 571-8501 (JP)**

(72) Inventor: **The designation of the inventor has not
yet been filed**

(74) Representative: **Grünecker, Kinkeldey,
Stockmair & Schwanhäusser
Anwaltssozietät
Leopoldstrasse 4
80802 München (DE)**

(54) **WIRING BOARD**

(57)      A wiring board includes an insulating board having a top surface arranged to have an electronic component mounted thereto, a conductor pattern formed on the top surface of the insulating board, and a heat emitting layer made of heat-emitting material covering the conductor pattern. The heat-emitting material has an emissivity not less than 0.8 for an electromagnetic wave having a wavelength $\lambda = 0.002898/T$ at a temperature T ranging from 293K to 473K. This wiring board suppresses the temperature rise of the electronic component.

## Fig. 1

## Description

TECHNICAL FIELD

The present invention relates to a wiring board arranged to have an electronic component mounted thereto.

BACKGROUND ART

Electronic components have recently had high performance, and accordingly had more power consumption, accordingly generating a more mount of heat. Patent Documents 1 and 2 disclose conventional wiring boards having such electronic components mounted thereto.

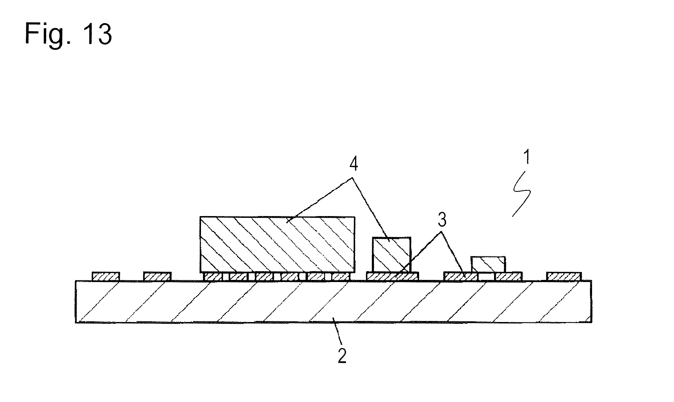

Fig. 13 is a sectional view of conventional wiring board 1. Wiring board 1 includes insulating board 2 and conductor pattern 3 formed on insulating board 2. Electronic component 4, such as a semiconductor, generating heat is mounted onto conductor pattern 3.

Electronic component 4, upon having a high temperature, raises a surface temperature of wiring board 1, preventing wiring board 1 from diffusing heat of electronic component 4 efficiently.

That is, heat generated from electronic component 4 transmits to conductor pattern 3. In generally, conductor pattern 3 has a small thermal emissivity, and insulating board 2 has small heat conductivity, thus the heat transmitting to conductor pattern 3 gradually raises the surface temperature of wiring board 1. This causes electronic component 4 to have a high temperature, and may cause breakage or malfunction of component 4.

Patent Document 1: JP 2007-35716A
Patent Document 2: JP 2005-252144A

SUMMARY OF THE INVENTION

A wiring board includes an insulating board having a top surface arranged to have an electronic component mounted thereto, a conductor pattern formed on the top surface of the insulating board, and a heat emitting layer made of heat-emitting material covering the conductor pattern. The heat-emitting material has an emissivity not less than 0.8 for an electromagnetic wave having a wavelength $\lambda = 0.002898/T$ at a temperature T ranging from 293K to 473K.

This wiring board suppresses the temperature rise of the electronic component.

BRIEF DESCRIPTION OF DRAWINGS

Fig. 1 is a sectional view of a wiring board according to Exemplary Embodiment 1 of the present invention. Fig. 2 shows the relationship between an emissivity and a wavelength of electromagnetic waves emitted from a heat emitting layer according to Embodiment 1.
Fig. 3 is a sectional view of a wiring board according to Exemplary Embodiment 2 of the invention.
Fig. 4 is a sectional view of a wiring board according to Exemplary Embodiment 3 of the invention.
Fig. 5 is a sectional view of a wiring board according to Exemplary Embodiment 4 of the invention.
Fig. 6 is a sectional view of another wiring board according to Embodiment 4.
Fig. 7 is a sectional view of a wiring board according to Exemplary Embodiment 5.
Fig. 8 is a sectional view of another wiring board according to Embodiment 5.
Fig. 9 is a sectional view of a wiring board according to Exemplary Embodiment 6 of the invention.
Fig. 10 is a sectional view of a wiring board according to Exemplary Embodiment 7 of the invention.
Fig. 11 is a sectional view of another wiring board according to Embodiment 7.
Fig. 12 is a sectional view of a wiring board according to Exemplary Embodiment 8 of the invention.
Fig. 13 is a sectional view of a conventional wiring board.

REFERENCE NUMERALS

| | |
|---|---|
| 5 | Wiring Board |
| 6 | Insulating Board |
| 7 | Conductor Pattern |
| 8 | Heat Emitting Layer |
| 9 | Electronic Component |
| 10 | Heat Emitting Layer |
| 11 | Resin Layer |
| 13 | Heat Emitting Layer |
| 105 | Wiring Board |
| 106 | Insulating Board |
| 107 | Conductor Pattern |
| 108 | Heat Emitting Layer |
| 109 | Electronic Component |
| 112 | Resin Layer |

DETAILED DESCRIPTION OF THE PREFERRED EMBODIMENTS

EXEMPLARY EMBODIMENT

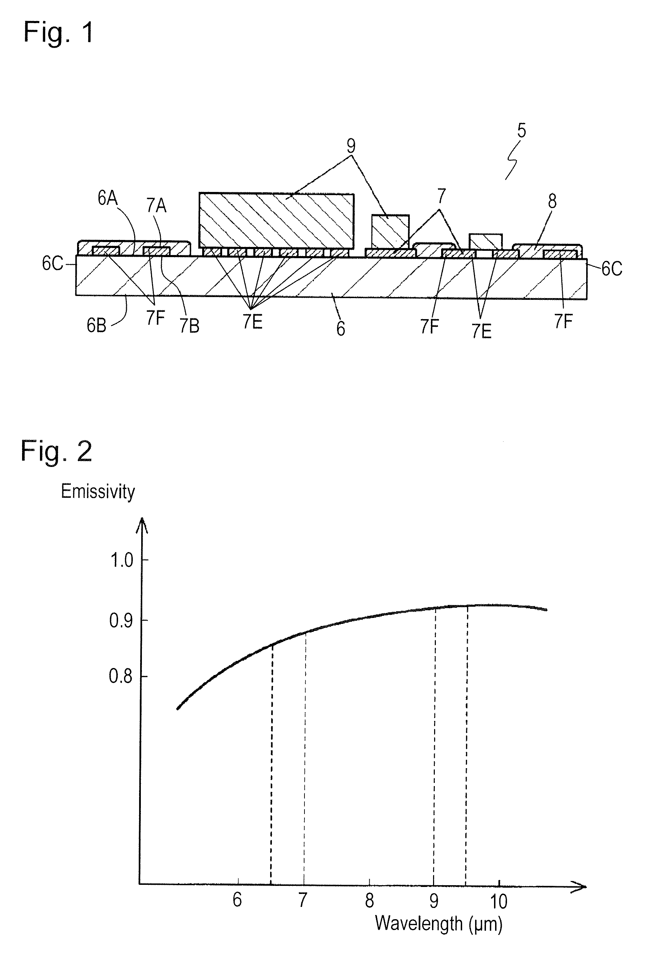

Fig. 1 is a sectional view of wiring board 5 according to Exemplary Embodiment 1 of the present invention. Wiring board 5 is a single-sided wiring board including insulating board 6, conductor pattern 7 formed on top surface 6A of insulating board 6, and heat emitting layer 8 covering conductor pattern 7 and top surface 6A of insulating board 6. Insulating board 6 has bottom surface 6B opposite to top surface 6A. Wiring board 5 is arranged to having electronic component 9, such as a semiconductor, generating heat mounted thereto. Top surface 6A of insulating board 6 is arranged to have electronic component 9 mounted thereto. Conductor pattern 7 is arranged to be connected to electronic component 9 by soldering. Conductor pattern 7 has portion 7E to which electronic component 9 is soldered and portion 7F to which electronic component 9 is not joined. Heat emitting layer 8 is formed substantially entirely on portion 7F of conductor pattern 7 and top surface 6A of insulating board 6 from outer periphery 6C of insulating board 6. Heat emitting layer 8 partially covers portion 7F of conductor pattern 7 and top surface 6A of insulating board 6. Conductor pattern 7 has bottom surface 7B facing insulating board 6 and top surface 7A opposite to bottom surface 7B. Heat emitting layer 8 is located directly above top surface 7A. In wiring board 5 according to Embodiment 1, heat emitting layer 8 is located on top surface 7A and contacts top surface 7A.

Heat emitting layer 8 is made of heat-emitting material. The heat-emitting material at temperature T ranging from 293K to 473K has an emissivity not less than 0.8 for an electromagnetic wave with a wavelength of $\lambda=0.002898/T$. The heat-emitting material contains insulator or semiconductor that has an emissivity not less than 0.9 for an electromagnetic wave (far-infrared rays) with a wavelength of $\lambda=0.002898/T$ under the same conditions.

In general, the spectrums of electromagnetic waves emitted from objects at temperature T(K) are substantially identical to each other regardless of the type of the objects. The wavelength $\lambda$max at which the intensity of the emitted electromagnetic waves emitted becomes maximum is expressed, according to Wien's displacement law, as the following formula.

$$\lambda\mathrm{max} = 0.002898/\mathrm{T}$$

The temperature of wiring board 5 rises, for example, from a room temperature of about 20°C (293K) to 200°C (473K), for example, by the heat from electronic component 9. In this case, the wavelength $\lambda$max at which the intensity of electromagnetic waves emitted from wiring board 5 becomes maximum ranges from $6.1\mu$m to $9.9\mu$m. Heat emitting layer 8 is made of the heat-emitting material having an emissivity not less than 0.8 for an electromagnetic wave with a wavelength $\lambda$ ranging from $9.9\mu$m to $6.1\mu$m at a temperature T ranging from 293K to 473K. Heat emitting layer 8 efficiently releases the heat from wiring board 5 having a temperature rising from 20°C to 200°C as far-infrared rays.

According to Embodiment 1, emitting layer 8 is formed substantially entirely on top surface 5A from the outer periphery of wiring board 5 except the portion of top surface 5A having electronic component 9 mounted thereto.

Insulating board 6 is made of glass epoxy including glass cloth and epoxy resin impregnated in the glass cloth. The epoxy resin contains about 5 vol% to 60 vol% of inorganic filler, such as aluminum oxide. The thickness of insulating board 6 is 0.9 mm. The inorganic filler and glass cloth function as a reinforcing material. Insulating board 6 contains the epoxy resin and the reinforcing material.

Insulating board 6 may be made of sole resin, mixture of resin and reinforcing material, or ceramic, besides the glass epoxy.

The resin may employ thermosetting resin, thermoplastic resin, or photocurable resin, such as a phenol resin, polyimide resin, epoxy resin, or silicone resin.

The epoxy resin, phenol resin, or isocyanate resin as the resin improves the heat resistance of insulating board 6.

According to Embodiment 1, the inorganic filler made of aluminum oxide and glass cloth are used as the reinforcing material of insulating board 6. However, another material may be used such as a filler made of silica, aluminum nitride, boron nitride, silicon nitride, or aluminum hydroxide, or a material, such as alumina cloth, carbon fiber, aramid cloth, or aramid nonwoven fabric, thereby improving the mechanical strength of insulating board 6.

Insulating board 6 may further contain a dispersant, coloring agent, coupling agent, or mold release agent, besides the reinforcing material.

Insulating board 6 may be made of ceramic, such as aluminum oxide, silicon nitride, or aluminum nitride.

Conductor pattern 7 is made of copper foil having a thickness of about 0.1mm and is bonded onto top surface 6A of insulating board 6. Copper foil can provide a circuit pattern easily and inexpensively by a simple method, such as etching, and has a high conductivity, being preferable.

Heat emitting layer 8 contains resin and about 20 vol% to 60 vol% of filler mixed in the resin. According to Embodiment 1, the resin is epoxy or acrylic resin. The filler is silicon carbide powder. The silicon carbide powder has an average particle diameter ranging about from $0.2\mu$m to $20\mu$m, thereby adjusting the content of the silicon carbide powder as appropriate for providing predetermined emissivity, viscosity, and photosensitivity.

The resin in heat emitting layer 8 may employ thermosetting resin, thermoplastic resin, or photocurable resin, such as phenol resin, polyimide resin, epoxy resin, or silicone resin. The photocurable resin can provide a predetermined pattern easily by photoresist (exposure and development) or screen printing.

The filler in heat emitting layer 8 may preferably be material having an emissivity not less than 0.9 for an electromagnetic wave with a wavelength $\lambda$ ($\lambda$ = 0.002898/T) at temperature T ranging from 293K to 473K. According to Embodiment 1, heat emitting layer 8 is formed on top surface 6A of insulating board 6 between conductor patterns 7 as well, and thus, is made of insulator or semiconductor. If the filler of heat emitting layer 8 is a semiconductor and is contained not less than 40 vol%, an insulating process may be preferably performed. The filler of heat emitting layer 8 may be glass, ceramic, carbide, nitride, or insulating metal oxide, such as titanium dioxide.

A smaller particle diameter of the filler of heat emitting layer 8 increases the specific surface area of the filler, and thus the average particle diameter is preferably not larger than 20$\mu$m. The content of the filler having the average particle diameter not larger than 20$\mu$m is adjusted appropriately to provide predetermined emissivity, viscosity, and photosensitivity. Fillers having different particle diameters may be mixed in heat emitting layer 8, thereby being contained at a high content.

According to Embodiment 1, the heat conductivity of heat emitting layer 8 and insulating board 6 is not smaller than 1.0 W/mK.

Insulating boards 6 and conductor patterns 7 may be stacked alternately. Conductor patterns 7 on different layers can be connected via an inner via-conductor, such as a through hole, plating, and a conductive paste, thereby providing a multilayer board. Both surfaces of the multilayer board may have components mounted thereon. In this case, heat emitting layers 8 may be provided on both surfaces of the multilayer board to increase heat-dissipation efficiency.

A method of manufacturing wiring board 5 will be described below.

First, a copper foil to be conductor pattern 7 is provided entirely on a surface of insulating board 6, an uncured prepreg sheet, and heated and pressed by a hot press machine to harden insulating board 6. Next, a resist is provided on the copper foil, exposed and developed, and then, the copper foil is etched, thereby providing conductor pattern 7. The resist on conductor pattern 7 is removed. Then, the heat-emitting material, resin containing filler, to be heat emitting layer 8 is applied onto insulating board 6 and conductor pattern 7. Next, the heat-emitting material is exposed and developed, and an unnecessary portion of the heat-emitting material, such as a soldered portion of the heat-emitting material, is removed to form heat emitting layer 8, thus providing wiring board 5. Heat emitting layer 8 may be formed by another method, such as printing.

Wiring board 5 according to Embodiment 1 efficiently releases heat from wiring board 5 through heat emitting layer 8, thereby suppressing the temperature rise of electronic component 9.

While heat generated by electronic component 9 is diffused by convection through air, radiation, and heat conduction to wiring board 5, the heat conduction out of them transmits the heat most efficiently. Thus, heat from electronic component 9 transmits to conductor pattern 7 quickly. Heat emitting layer 8 provided on conductor pattern 7 and top surface 6A of insulating board 6 releases the heat transmitted to conductor pattern 7 to an outside of wiring board 5 as far-infrared rays on the surface of wiring board 5 having a temperature generally rising from a room temperature of 20°C to 200°C. This prevents the temperature of electronic component 9 from rising.

Energy entering into a surface of an object is absorbed at absorptivity $\alpha$, reflected on the surface at reflectivity $\rho$, and transmits through the object at transmittance $\tau$. Assuming the amount of incident energy being 1, the following condition is satisfied.

$$\alpha + \rho + \tau = 1$$

According to Kirchhoff's law, emissivity $\varepsilon$ is equal to absorptivity $\alpha$, and thus, the following condition is satisfied.

$$\varepsilon + \rho + \tau = 1$$

Conductor pattern 7 is often made of metal likely to reflect incident energy, thus having a low heat radiation. Although conductor pattern 7 made of metal does not transmit light, conductor pattern 7 has low transmittance $\tau$ of about 0.1, and high reflectivity $\rho$ of about 0.9, thus having low emissivity $\varepsilon$.

Resins often have relatively high emissivity $\varepsilon$. Heat emitting layer 8 contains resin and is provided around a soldered portion, i.e., at a portion other than the soldered portion. Heat emitting layer 8 prevents solder from unnecessarily spreading on wiring board 5 when electronic component 9 is mounted to wiring board 5, thus functioning as a solder resist.

In general, only a known solder resist does not provide sufficient heat dissipation. Since the known solder resist is designed mainly aiming patterning and adhesion, a solder resist containing filler of appropriate material and particle diameter is required in order to increase the emissivity.

According to Embodiment 1, heat emitting layer 8 functions as the solder resist to reduce manufacturing process and material cost. A wiring board according to Embodiment 1 may include a solder resist (resin layer) provided on heat emitting layer 8, or heat emitting layer 8 may be formed on a solder resist (resin layer). In the latter case, the solder resist is preferable made of material which has an average reflectivity not higher than 10% and an average transmittance not lower than 90% for far-infrared rays (having a wavelength ranging from 6.1$\mu$m to 9.9$\mu$m) emitted from heat emitting layer 8, thereby preventing the solder resist from reflecting far-infrared rays emitted from heat emitting layer 8.

According to Embodiment 1, heat emitting layer 8 is formed substantially entirely on the surface of the wiring board 5 except the soldered portion having electronic component 9 mounted thereto. This arrangement increases an area emitting heat due to the large area of heat emitting layer 8, thereby increasing heat dissipation.

According to Embodiment 1, heat emitting layer 8 may contain 5 vol% to 60 vol% of semiconductor particles. This arrangement provides sufficient heat dissipation while preventing the viscosity of the resin from excessively increasing and while allowing layer 8 as photosensitive resin to be easily exposed. In the case that resin having a lower viscosity is used or that the viscosity can be decreased by adding additive, such as a solvent, heat emitting layer 8 may contain more than 60 vol% of particles of insulator or semiconductor.

According to Embodiment 1, heat emitting layer 8 may contain semiconductor particles having an average particle diameter ranging from $0.2\mu m$ to $20\mu m$. This arrangement allows the resin to contain the semiconductor particles at a high content to increase heat dissipation while preventing the viscosity of the resin from excessively increasing. In the case that the resin having a lower viscosity is used, the particle diameter of semiconductor particles (or insulator particles) may be smaller than $0.2\mu m$ as to increase a specific surface area of the semiconductor particles, thereby increasing heat dissipation.

According to Embodiment 1, the resin in heat emitting layer 8 contains insulator or semiconductor particles, i.e. inorganic compound. The particles function as heat conducting filler to raise the heat conductivity of heat emitting layer 8 to higher than 1.0 W/mK, which is higher than the heat conductivity of the resin itself. Heat is transmitted easily inside heat emitting layer 8. Hence, the heat from electronic component 9 is diffused more extensively to dissipate heat more efficiently, thus further decreasing the temperature of the surface of wiring board 5.

Fig. 2 shows the relationship between the emissivity and the wavelength of electromagnetic waves emitted by heat emitting layer 8. As shown in Fig. 2, the heat-emitting material, i.e., the material of heat emitting layer 8, may preferably have an average emissivity for an electromagnetic wave having a wavelength ranging from $9.0\mu m$ to $9.5\mu m$ higher than an average emissivity for an electromagnetic wave having a wavelength ranging from $6.5\mu m$ to $7.0\mu m$. Wiring board 5 has a lower temperature than electronic component 9 generating the heat. The heat is emitted from heat emitting layer 8 of wiring board 5 having the lower temperature more than from electronic component 9 having the higher temperature as far-infrared rays. Thus, heat emitting layer 8 dissipates the heat on wiring board 5 more effectively.

A wavelength range of far-infrared rays emitted from an object at a temperature ranging from about 20°C to 200°C (293K to 473K) is from about $9\mu m$ to $6.1\mu m$. The object having a higher emissivity in a long-wavelength range from $9.0\mu m$ to $9.5\mu m$ out of the wavelength range has high heat dissipation at low temperatures. The object having a low emissivity (absorptivity) of far-infrared rays in a short-wavelength range from $6.5\mu m$ to $7.0\mu m$ out of the wavelength range which is shorter than the long-wavelength range can hardly absorb far-infrared rays at high temperatures. Hence, heat emitting layer 8 easily absorb far-infrared rays in the short-wavelength range from electronic component 9, thereby emitting the heat on the surface of wiring board 5 efficiently.

EXEMPLARY EMBODIMENT 2

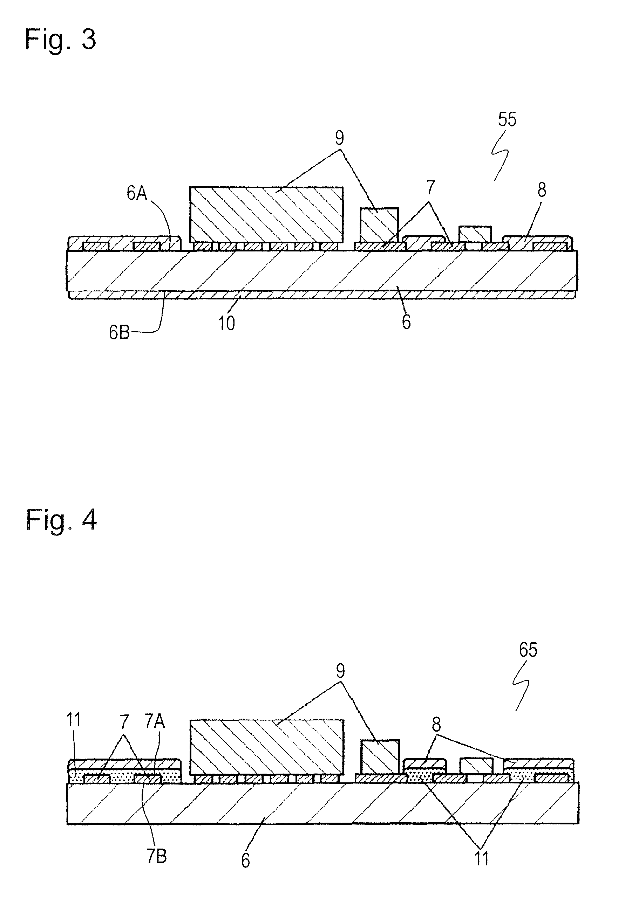

Fig. 3 is a sectional view of wiring board 55 according to Exemplary Embodiment 2. In Fig. 3, components identical to those of wiring board 5 of Embodiment 1 shown in Fig. 1 are denoted by the same reference numerals, and their description will be omitted.

Wiring board 55 further includes heat emitting layer 10 made of heat-emitting material provided on bottom surface 6B opposite to top surface 6A of insulating board 6 of wiring board 5 according to Embodiment 1 shown in Fig. 1. Bottom surface 6B of insulating board 6 does not have a conductor pattern formed thereon, and allows heat emitting layer 10 to be formed substantially entirely on bottom surface 6B of insulating board 6.

When a temperature T of the heat-emitting material of heat emitting layer 10 ranges from 293K to 473K, the heat-emitting material has an emissivity not less than 0.8 for an electromagnetic wave having wavelength $\lambda$ ($\lambda = 0.002898/T$. Bottom surface 6B of insulating board 6 does not have a conductor pattern formed thereon, heat emitting layer 10 can contain conductor particles, such as carbon. The average emissivity of electromagnetic waves with wavelengths ranging from $9.0\mu m$ to $9.5\mu m$ emitted from heat emitting layer 10 is higher than that from heat emitting layer 8.

In wiring board 55, emitting layer 8 provided on top surface 6A of insulating board 6 and heat emitting layer 10 provided on bottom surface 6B of insulating board 6 allow heat to be emitted from both surfaces of wiring board 55 (insulating board 6).

In wiring board 55, heat emitting layer 10 formed on bottom surface 6B has a heat emissivity in the long-wavelength range higher than heat emitting layer 8 formed on top surface 6A having electronic component 9 mounted thereto. Top surface 6A has electronic component 9 generating heat mounted thereto, and thus, bottom surface 6B has a lower temperature than top surface 6A. Heat emitting layer 10 provided on bottom surface 6B efficiently emits far-infrared rays in the long-wavelength range emitted from an object having a low temperature. Thus, wiring board 55 (insulating board 6) has a high heat emissivity on both top surface 6A and bottom surface 6B, and releases the heat of electronic component 9, accordingly preventing the temperature of electronic component 9 from rising.

EXEMPLARY EMBODIMENT 3

Fig. 4 is a sectional view of wiring board 65 according to Exemplary Embodiment 3. In Fig. 4, components identical to those of wiring board 5 of Embodiment 1 shown in Fig. 1 are denoted by the same reference numerals, and their description will be omitted.

Wiring board 65 further includes resin layer 11 provided between top surface 6A of insulating board 6 and heat emitting layer 8 of wiring board 5 according to Embodiment 1 shown in Fig. 1. Resin layer 11 is provided on conductor pattern 7 and on top surface 6A of insulating board 6. Heat emitting layer 8 is provided on resin layer 11. Resin layer 11 prevents a solder from unnecessarily spreading on wiring board 65 (insulating board 6) when electronic component 9 is mounted on wiring board 65 (insulating board 6), and thus resin layer 11 functions as a solder resist. Resin layer 11 and heat emitting layer 8 cover substantially entirely top surface 6A having electronic component 9 mounted thereto and conductor pattern 7 except respective portions of conductor pattern 7 and top surface 6A facing electronic component 9 and a portion of conductor pattern 7 soldered to electronic component 9. That is, heat emitting layer 8 covers conductor pattern 7 and top surface 6A of insulating board 6. Heat emitting layer 8 is located directly above top surface 7A of conductor pattern 7. In wiring board 65 according to Embodiment 3, heat emitting layer 8 faces top surface 7A of conductor pattern 7 across resin layer 11, and is located away from conductor pattern 7, i.e., does not contact pattern 7.

Resin layer 11 has a reflectivity not less than 80% for electromagnetic waves with wavelengths ranging from 6.1$\mu$m to 9.9$\mu$m, and may be made of polycarbonate resin or fluorine resin. Resin layer 11 does not absorb or reflect far-infrared rays emitted from top surface 6A of insulating board 6, thereby efficiently emitting heat of the far-infrared rays from heat emitting layer 8.

In wiring board 65, resin layer 11 contacts conductor pattern 7 and top surface 6A. Heat emitting layer 8 provided on resin layer 11 does not contact conductor pattern 7. Thus, heat emitting layer 8 may contain either conductor particles, semiconductor particles, or insulator particles.

Wiring board 65 provides the same effects as wiring board 5 according to Embodiment 1.

EXEMPLARY EMBODIMENT 4

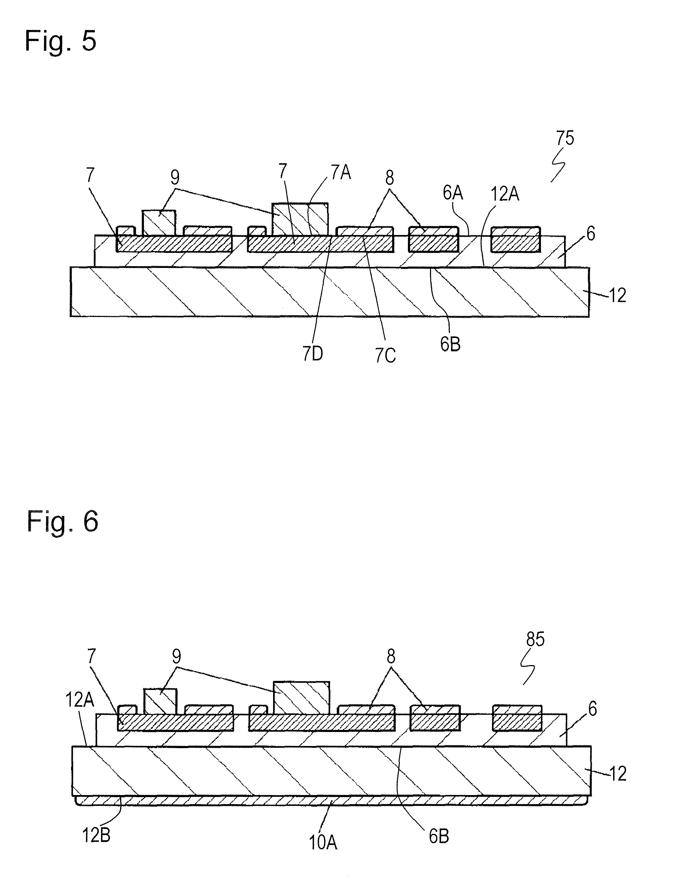

Fig. 5 is a sectional view of wiring board 75 according to Exemplary Embodiment 4. In Fig. 5, components identical to those of wiring board 5 of Embodiment 1 shown in Fig. 1 are denoted by the same reference numerals, and their description will be omitted.

In wiring board 75, conductor pattern 7 is made of a thick copper plate and is embedded in top surface 6A of insulating board 6. Top surface 7A of conductor pattern 7 is flush with top surface 6A of insulating board 6 and is exposed. Heat emitting layer 8 is formed on portion 7C of top surface 7A of conductor pattern 7. Top surface 7A has portion 7D where heat emitting layer 8 is not provided. Heat emitting layer 8 does not extend onto top surface 6A of insulating board 6. Filler contained in heat emitting layer 8 is conductor. Heat sink 12 is provided on bottom surface 6B of insulating board 6. That is, top surface 12A of heat sink 12 is situated on bottom surface 6B of insulating board 6.

Heat emitting layer 8 contains resin and 50 vol% of filler made of graphite particles mixed in the resin.

Conductor pattern 7 is made of a tough pitch copper plate having a thickness ranging from 0.1mm to 2.0mm.

Insulating board 6 contains thermosetting resin and 70 wt% to 95 wt% of filler mixed in the thermosetting resin. The thermosetting resin may be epoxy resin, phenol resin, or cyanate resin. The filler is made of $Al_2O_3$, MgO, $SiO_2$, BN, or AlN. In order to mix the filler in the resin at such high content, the particle diameter of the filler ranges from 0.1$\mu$m to 100$\mu$m including a group having a larger average particle diameter and a group having a smaller average particle diameter. The filler mixed in the resin at such high content increases the heat conductivity of insulating board 6 to more than 2.0 W/mK.

Heat sink 12 is made of an aluminum plate having a thickness ranging from about 0.5mm to 3.0mm.

A method of manufacturing wiring board 75 according to Embodiment 5 will be described below.

First, a tough pitch copper plate is press-punched with a die or etched to produce conductor pattern 7. Conductor pattern 7 is thick and has a resistance low enough to flow a large current therein.

Next, a piece of the resin containing the filler to be insulating board 6 is put on conductor pattern 7, and then spread. At this moment, conductor pattern 7 is embedded in insulating board 6 to expose top surface 7A of conductor pattern 7 from top surface 6A of insulating board 6. After that, heat sink 12 is placed on bottom surface 6B of insulating board 6 to sandwich insulating board 6 between conductor pattern 7 and heat sink 12. After that, the resin of insulating board 6 is hardened at a temperature of about 200°C.

Then, heat emitting layer 8 is formed on top surface 7A of conductor pattern 7 along conductor pattern 7 by screen printing. According to Embodiment 4, heat emitting layer 8 is formed exclusively on portion 7C of top surface 7A of conductor pattern 7, and is not formed on portion 7D of top surface 7A of conductor pattern 7 or on top surface 6A of insulating board 6.

Wiring board 75 efficiently releases heat of conductor pattern 7 through heat emitting layer 8 exclusively formed on top surface 7A of conductor pattern 7. Conductor pattern 7 has a large thickness ranging from 0.1mm to 1.5mm, a high thermal conductivity of about 400 W/mK, and a low heat resistance. Insulating board 6 has a heat conductivity lower than the heat conductivity of about 2 W/mK of conductor pattern 7. Heat generated form electronic component 9 mounted onto top surface 7A of conductor pattern 7 and onto top surface 6A of insulating board 6 is transmitted to conductor pattern 7 more than to insulating board 6. Thus, heat emitting layer 8 can release the heat more efficiently.

Heat emitting layer 8 is not formed uniformly entirely on top surface 6A of insulating board 6 or entirely on top surface 7A of conductor pattern 7, but is formed partially on top surface 7A of conductor pattern 7. Thus, heat emitting layer 8 becomes extremely close to electronic component 9 generating the heat, thus absorbing and emitting far-infrared rays from electronic component 9 efficiently.

In wiring board 75, top surface 7A of conductor pattern 7 is substantively flush with top surface 6A of insulating board 6. Thus, top surface 6A of insulating board 6 is not uneven, and allowing heat emitting layer 8 to be easily formed by screen printing.

According to Embodiment 4, heat emitting layer 8 is formed by screen printing. Layer 8 may be formed by another method, such as electro-deposition coating. In this case, if conductor pattern 7 is made of a single plate and is electrically continuous as a whole, heat emitting layer 8 can be applied at once at high productivity, and formed reliably on a predetermined position within top surface 7A of conductor pattern 7.

In wiring board 75, heat emitting layer 8 is formed only on top surface 7A of conductor pattern 7, not on top surface 6A of insulating board 6. Hence, even if heat emitting layer 8 has a high viscosity, layer 8 is easily formed. In wiring board 75, heat emitting layer 8 can contain graphite particles (conductor particles) as the filler at high content of about 50 vol%, accordingly increasing heat dissipation.

Heat sink 12 provided on bottom surface 6B of insulating board 6 releases, through insulating board 6, heat that is not dissipated from heat emitting layer 8. This prevents the top surface 6A of insulating board 6 more effectively from rising.

Further, heat sink 12 may closely contact a case accommodating wiring board 75, thereby diffusing heat due to heat conduction of the contact.

Fig. 6 is a sectional view of another wiring board 85 according to Embodiment 4. In Fig. 6, components identical to those of wiring board 75 shown in Fig. 5 are denoted by the same reference numerals, and their description will be omitted.

Wiring board 85 further includes heat emitting layer 10A provided on bottom surface 12B of heat sink 12 of wiring board 75 shown in Fig. 5. If insulating board 6 has a relatively high heat conductivity, heat emitting layer 10A provided on bottom surface 12B of heat sink 12 emits heat effectively through wiring board 85 (insulating board 6).

A larger area for emitting heat is effective to increase heat dissipation. Thus, heat emitting layer 8 and heat emitting layer 10A may roughed to release heat efficiently.

Heat sink 12 and heat emitting layer 10A may securely contact a case accommodating wiring board 85 to diffuse heat due to heat conduction by the contact.

EXEMPLARY EMBODIMENT 5

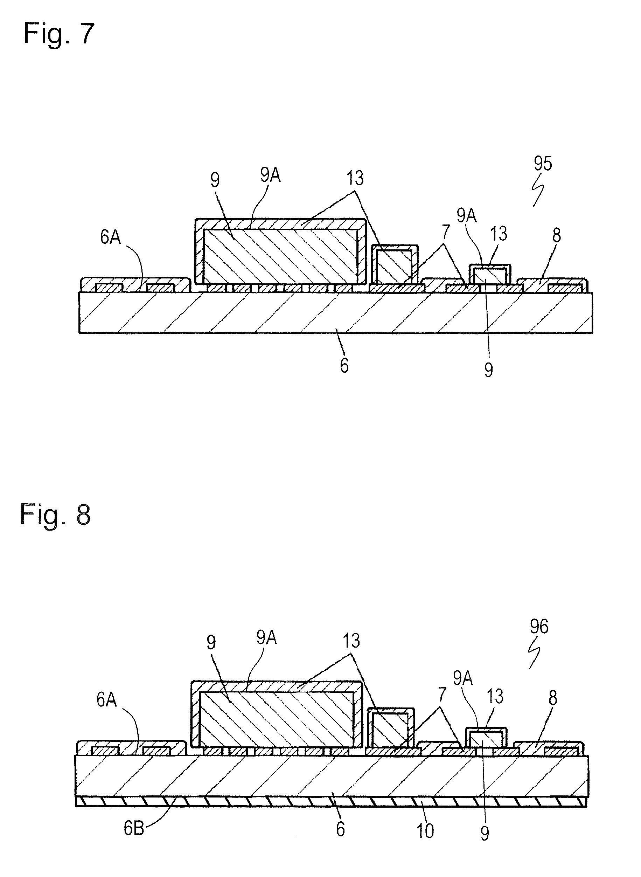

Fig. 7 is a sectional view of wiring board 95 according to Exemplary Embodiment 5. In Fig. 7, components identical to those of wiring board 5 according to Embodiment 1 shown in Fig. 1 are denoted by the same reference numerals, and their description will be omitted.

Wiring board 95 further includes heat emitting layer 13 provided on surface 9A of electronic component 9 of wiring board 5 shown in Fig. 1. Heat emitting layer 13 receives heat from electronic component 9 to emit the received heat. Heat emitting layers 8 and 13 release heat through surface 9A of electronic component 9, top surface 6A of insulating board 6, and conductor pattern 7.

Heat emitting layer 13, similarly to heat emitting layer 8, is made of heat-emitting material having an emissivity not less than 0.8 for an electromagnetic wave with wavelength $\lambda$ ($\lambda = 0.002898/T$) at a temperature T ranging from 293K to 473K, efficiently releasing heat.

The average emissivity of electromagnetic waves with wavelengths ranging from 6.5$\mu$m to 7.0$\mu$m emitted from heat emitting layer 13 is higher than that from heat emitting layer 8. Heat emitting layer 13 efficiently emits far-infrared rays in the short-wavelength range, thereby effectively preventing the temperature of electronic component 9 from rising.

Fig. 8 is a sectional view of another wiring board 96 according to Embodiment 5. In Fig. 8, components identical to those of wiring board 95 shown in Fig. 7 are denoted by the same reference numerals, and their description will be omitted.

Wiring board 96 further includes heat emitting layer 10 provided on bottom surface 6B of insulating board 6 of wiring board 95 shown in Fig. 7. Heat emitting layer 10 is made of the same material as that of wiring board 55 according to Embodiment 2 shown in Fig. 3m providing the same effects.

Heat emitting layer 13 has an average emissivity of electromagnetic waves having wavelengths ranging from 6.5$\mu$m to 7.0$\mu$m is higher than that of each of heat emitting layers 8 and 10. Heat emitting layer 13 emits far-infrared rays in the short-wavelength range efficiently, thereby effectively preventing the temperature of electronic component 9 from rising.

According to Embodiments 1 to 5, wiring board 5 may be a double-sided wiring board or a multilayer wiring board. Both top surface 6A and bottom surface 6B of insulating board 6 have electronic components mounted thereon. Thus, a heat emitting layer made of the heat-emitting material of heat emitting layer 8 may be on bottom surface 6B of insulating board 6, increasing heat dissipation. When one of top surface 6A and bottom surface 6B excessively generates heat, the heat is rapidly released through heat emitting layer 8 on top surface 6A to reduce heat transmitting another surface of surfaces 6A and 6B, thus preventing the temperature of another surface from rising.

Conductor pattern 7 may not necessarily constitute a circuit, but may be a conductor just for dissipating heat.

EXEMPLARY EMBODIMENT 6

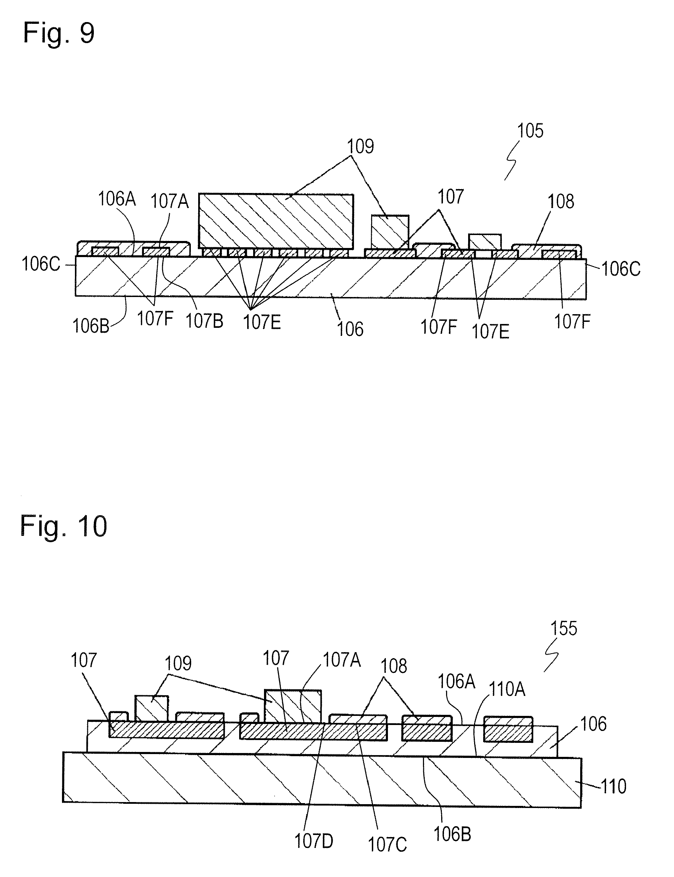

Fig. 9 is a sectional view of wiring board 105 according to Exemplary Embodiment 6 of the present invention. Wiring board 105 is a single-sided wiring board including insulating board 106, conductor pattern 107 formed on top surface 106A of insulating board 106, and heat emitting layer 108 partially covering top surface 106A of insulating board 106 and conductor pattern 107. Insulating board 106 has bottom surface 106B opposite to top surface 106A. Wiring board 105 is arranged to have electronic component 109, such as a semiconductor, generating heat mounted thereto. Top surface 106A of insulating board 106 is arranged to have electronic component 109 mounted thereto. Conductor pattern 107 is arranged to be connected to electronic component 109 by soldering. Conductor pattern 107 has portion 107E having electronic component 109, such as a semiconductor, generating heat soldered thereon and portion 107F to which electronic component 9 is not joined. Heat emitting layer 108 is provided substantially entirely on portion 107E of conductor pattern 107 and top surface 106A of insulating board 106 have heat emitting layer 108 from outer periphery 106C of insulating board 106. Conductor pattern 107 has bottom surface 107B facing insulating board 106 and top surface 107A opposite to bottom surface 107B. Heat emitting layer 108 is located directly above top surface 107A. In wiring board 105 according to Embodiment 6, heat emitting layer 108 is located on top surface 107A and contacts top surface 107A.

Heat emitting layer 108 contains resin and 5.0 vol% to 40 vol% of N-type semiconductor particles.

Insulating board 106 is made of glass epoxy including glass cloth and epoxy resin impregnated in the glass cloth. The epoxy resin contains about 5 vol% to 60 vol% of inorganic filler, such as aluminum oxide. The thickness of insulating board 106 is 0.9mm. The inorganic filler and glass cloth function as a reinforcing material. Insulating board 106 includes the epoxy resin and the reinforcing material.

Insulating board 106 may be made of sole resin, mixture of resin and reinforcing material, or ceramic, besides the glass epoxy.

The resin may be thermosetting resin, thermoplastic resin, or photocurable resin, such as a phenol resin, polyimide resin, epoxy resin, or silicon resin.

The epoxy resin, phenol resin, or isocyanate resin as the resin increases resistance of insulating board 106 heat.

According to Embodiment 6, the inorganic filler made of aluminum oxide and the glass cloth function as the reinforcing material of insulating board 106. However, other material, such as filler made of silica, aluminum nitride, boron nitride, silicon nitride, or aluminum hydroxide, and a structure, such as alumina cloth, carbon fiber, aramid cloth, or aramid nonwoven fabric may be used, thereby increasing mechanical strength of insulating board 106.

Insulating board 106 may further contain dispersant, coloring agent, coupling agent, or mold release agent.

Insulating board 106 may be made of ceramic, such as aluminum oxide, silicon nitride, or aluminum nitride.

Conductor pattern 107 is made of copper foil having a thickness of about 0.1mm and is bonded onto top surface 106A of insulating board 106. The copper foil provides a circuit pattern easily by a simple method, such as etching, inexpensively, and has a high conductivity.

Heat emitting layer 108 contains the resin and 5.0 vol% to 40 vol% of N-type semiconductor particles mixed in the resin. According to Embodiment 6, the N-type semiconductor particles are powder of titanium oxide having an average particle diameter of $1.0\mu m$. The resin of heat emitting layer 108 may be epoxy or acrylic resin. According to Embodiment 6, the thickness of heat emitting layer 108 is about $50\mu m$. The N-type semiconductor particles having the average particle diameter ranging from about $0.1\mu m$ to $20\mu m$ may be adjusted in its content to provide predetermined emissivity, viscosity, and photosensitivity.

The resin of heat emitting layer 108 may be thermosetting resin, thermoplastic resin, or photocurable resin such, as phenol resin, polyimide resin, epoxy resin, and silicon resin. The photocurable resin can provide a predetermined pattern easily by photoresist technique (exposure and development) or screen printing.

The N-type semiconductor particles may be made of silicon or germanium mixed (doped) with arsenic or phosphorus, besides titanium oxide.

The particle diameter of the semiconductor particles for heat emitting layer 108 is reduced to increase a specific surface area of the particles, and thus, their average particle diameter is preferably smaller than $20\mu m$. The content of the semiconductor particles having the average particle diameter smaller than $20\mu m$ is adjusted appropriately to provide predetermined desired emissivity, viscosity, and photosensitive. Semiconductor particles having different particle diameters may be contained in heat emitting layer 108 at a high content.

Each of insulating board 106 and conductor pattern 107 may be a multilayer board including conductor patterns 7 on different layers connected via an inner viaconductor, such as a through hole, plating, and a conductive paste. Heat emitting layers 108 may be provided on each surface of the multilayer board to increase heat dissipation.

A method of manufacturing wiring board 105 will be described below.

First, a copper foil to be conductor pattern 107 is stacked entirely on a surface of insulating board 106, an uncured prepreg sheet, and heated and pressed by a hot press machine to harden insulating board 106. Next, a resist is formed on the copper foil, exposed and developed. The copper foil is then etched to form conductor pattern 107. After the resist on conductor pattern 107 is removed, the heat-emitting material, the resin containing the semiconductor particles to be heat emitting layer 108 is applied onto insulating board 106 and conductor pattern 107. Next, the heat-emitting material is exposed and developed, and an unnecessary portion, such as a soldered portion, of the heat-emitting material is removed to form heat emitting layer 108, thereby producing wiring board 105. Heat emitting layer 108 may be formed by another method, such as printing.

Wiring board 105 according to Embodiment 6 efficiently releases heat from wiring board 105 through heat emitting layer 108 containing N-type semiconductor particles, thereby preventing the temperature of electronic component 109 from rising.

Heat generated by electronic component 109 is diffused by convection through air, radiation, and heat conduction to wiring board 105. The heat conduction out of them allows the heat to transmit most efficiently. Thus, heat from electronic component 109 transmits to conductor pattern 107 relatively fast.

In wiring board 105, electrons in the N-type semiconductor particles contained in heat emitting layer 108 are excited by obtaining energy from heat from electronic component 109 and top surface 6A of insulating board 6 to move from a valence band to a conduction band. When the excited electrons fall to a lower orbit, the energy is emitted as light energy having a wavelength according to a band gap between the conduction band and valence band. This increases heat dissipation from the surface of wiring board 105 and prevents the temperature of electronic component 109 from rising.

Energy entering into a surface of an object is absorbed at absorptivity $\alpha$, reflected on the surface at reflectivity $\rho$, and transmits through the object at transmittance $\tau$. Assuming the amount of incident energy being 1, the following condition is satisfied.

$$\alpha + \rho + \tau = 1$$

According to Kirchhoff's law, emissivity $\varepsilon$ is equal to absorptivity $\alpha$, and thus, the following condition is satisfied.

$$\varepsilon + \rho + \tau = 1$$

Conductor pattern 7 is often made of metal likely to reflect incident energy, thus having a low heat radiation. Although conductor pattern 7 made of metal does not transmit light, conductor pattern 7 has low transmittance $\tau$ of about 0.1, and high reflectivity $\rho$ of about 0.9, thus having low emissivity $\varepsilon$.

Resins often have relatively high emissivity $\varepsilon$. Heat emitting layer 8 contains resin and is provided around a soldered portion, i.e., at a portion other than the soldered portion. Heat emitting layer 8 prevents solder from unnecessarily spreading on wiring board 5 when electronic component 9 is mounted to wiring board 5, thus functioning as a solder resist.

In general, only a known solder resist does not provide sufficient heat dissipation. Since the known solder resist is designed mainly aiming patterning and adhesion, a solder resist containing filler of appropriate material and particle diameter is required in order to increase the emissivity.

In wiring board 105, heat emitting layer 108 containing 5.0 vol% or more of N-type semiconductor particles is easily exposed as a photosensitive resin and has sufficient heat dissipation.

The content of the N-type semiconductor particles in heat emitting layer 108 is not more than 40 vol% to provide electrical insulation between conductor patterns 107. If insulating process is performed to the N-type semiconductor particles, heat emitting layer 108 may contain up to about 60 vol% of the N-type semiconductor particles. A larger content of the N-type semiconductor particles increases the viscosity of heat emitting layer 108. In order to contain more than 60 vol% of the N-type semiconductor particles, heat emitting layer 108 may contain resin having a lower viscosity, or may contain additive, such as solvent to decrease the viscosity.

According to Embodiment 6, heat emitting layer 108 contains the N-type semiconductor particles having an average particle diameter ranging from 0.1$\mu$m to 20$\mu$m, thereby allowing a high content of the N-type semiconductor particles to be mixed without excessively increasing the viscosity of the heat-emitting material, material of heat emitting layer 108. In the case that resin with a low viscosity is used as the heat-emitting material or that the viscosity of the heat-emitting material is decreased with additive, such as solvent, the particle diameter of N-type semiconductor particles may be smaller than 0.1$\mu$m, thereby increasing the specific surface area of the N-type semiconductor particles contributing to heat dissipation.

According to Embodiment 6, the N-type semiconductor particles contained in the resin of heat emitting layer 108 function as heat-conductive filler, thereby increasing heat conductivity of heat emitting layer 108 higher than the sole resin. Thus, heat can transmit inside of heat emitting layer 108, and the heat from electronic component 109 is diffused more extensively to be released more efficiently, accordingly decreasing the surface temperature of wiring board 105.

According to Embodiment 6, heat emitting layer 108 contains only the N-type semiconductor particles, but it may further contain insulating heat-conductive filler, such as aluminum oxide. This allows heat to transmit inside of heat emitting layer 108, the heat from electronic component 109 is diffused more extensively to be released more efficiently, accordingly decreasing the surface temperature of wiring board 105.

According to Embodiment 6, wiring board 105 may be either a double-sided wiring board or a multilayer wiring board. Electronic components are mounted on both top surface 106A and bottom surface 106B of insulating board 106. Heat emitting layer 108 identical to heat emitting layer 8 may be provided on bottom surface 106B of insulating board 106, thereby increasing heat dissipation. When one of top surface 106A and bottom surface 106B excessively generates heat, the heat is rapidly released through heat emitting layer 108 on top surface 106A to reduce heat transmitted to another surface of surfaces 106A and 106V, accordingly preventing the temperature of another surface from rising.

EXEMPLARY EMBODIMENT 7

Fig. 10 is a sectional view of wiring board 155 according to Exemplary Embodiment 7. In Fig. 10, components identical to those of wiring board 105 according to Embodiment 6 shown in Fig. 9 are denoted by the same reference numerals, and their description will be omitted.

In wiring board 155, conductor pattern 107 is made of a thick copper plate and embedded in top surface 106A of insulating board 106. Top surface 107A of conductor pattern 107 is substantively flush with top surface 106A of insulating board 106 and is exposed. Heat emitting layer 108 is formed on portion 107C of top surface 107A of conductor pattern 107. Top surface 107A has portion 107D on which heat emitting layer 108 is not provided. Heat emitting layer 108 does not extend onto top surface 106A of insulating board 106. Heat sink 110 is provided on bottom surface 106B of insulating board 106. That is, top surface 110A of heat sink 110 is situated on bottom surface 106B of insulating board 106.

Heat emitting layer 108 can contain more than 40 vol% of N-type semiconductor particles regardless of whether the particles are insulated or not.

Conductor pattern 107 is made of a tough pitch copper plate having a thickness ranging from 0.1mm to 2.0mm.

Insulating board 106 contains thermosetting resin and 70 wt% to 95 wt% of filler mixed in the thermosetting resin. The thermosetting resin may be epoxy resin, phenol resin, or cyanate resin. The filler is made of $Al_2O_3$, MgO, $SiO_2$, BN, or AlN. In order to mix the filler in the resin at such high content, the particle diameter of the filler ranges from $0.1\mu m$ to $100\mu m$. The particles include a group having a larger average particle diameter and a group having a smaller one. The filler mixed in the resin at such high content increases the heat conductivity of insulating board 106 to 2.0 W/mK or higher.

The thickness of insulating board 106 is not smaller than 0.6mm to provide the board with a high withstand voltage.

Heat sink 110 is made of an aluminum plate having a thickness ranging from about 0.5mm to 3.0mm.

A method of manufacturing wiring board 155 will be described below.

First, a wiring pattern is formed on a tough pitch copper plate by press die-cutting or etching to produce conductor pattern 107. Conductor pattern 107 is thick, and has a small resistance, accordingly allowing a large current to flow therein.

Next, a piece of the resin containing the filler to be insulating board 106 is put on conductor pattern 107, and then spread. At this moment, conductor pattern 107 is embedded in insulating board 106 so that top surface 107A of conductor pattern 107 is exposed on top surface 106A of insulating board 106. After that, heat sink 110 is placed on bottom surface 106B of insulating board 106 to sandwich insulating board 106 between conductor pattern 107 and heat sink 110. After that, the resin of insulating board 106 is polymerized at a temperature of about 200°C to be hardened.

After that, heat emitting layer 108 is formed on top surface 107A of conductor pattern 107 along conductor pattern 107 by screen printing. According to Embodiment 7, heat emitting layer 108 is formed exclusively on portion 107C of top surface 107A of conductor pattern 107, and is not formed on portion 107D of top surface 107A of conductor pattern 107 or on top surface 106A of insulating board 106.

Wiring board 75 efficiently releases heat of conductor pattern 107 through heat emitting layer 108 exclusively formed on top surface 107A of conductor pattern 107. Conductor pattern 107 has a large thickness ranging from 0.1mm to 1.5mm, a high thermal conductivity of about 400 W/mK, and a low heat resistance. Insulating board 106 has a heat conductivity lower than a heat conductivity of about 2 W/mK of conductor pattern 7. Heat generated from electronic component 109 mounted to top surface 107A of conductor pattern 107 and top surface 106A of insulating board 106 transmits to conductor pattern 107 more than to insulating board 106. Thus, heat emitting layer 108 releases the heat as light energy efficiently.

According to Embodiment 7, heat emitting layer 108 is not formed on top surface 106A of insulating board 106 having a low heat conductivity, but is provided exclusively on top surface 107A of conductor pattern 107 having a higher temperature, thus enabling cost reduction.

Heat emitting layer 108 is not formed on insulating board 6, but is formed exclusively on conductor pattern 107, thus not being required to have insulating property. Consequently, heat emitting layer 108 can contain up to about 60 vol% of the N-type semiconductor particles, providing a high heat dissipation.

In wiring board 155, top surface 107A of conductor pattern 107 is substantively flush with top surface 106A of insulating board 106. Thus, top surface 106A of insulating board 106 is not so uneven, that heat emitting layer 108 can be easily formed by screen printing.

According to Embodiment 7, heat emitting layer 108 is formed by screen printing. However, layer 108 may be formed by another method, such as electro-deposition coating. In this case, if conductor pattern 107 is made of a single plate and is electrically continuous as a whole, heat emitting layer 108 can be applied at once at high productivity and can be formed reliably on a predetermined portion of top surface 107A of conductor pattern 107. Heat emitting layer 108 formed by electro-deposition coating increases the content of N-type semiconductor particles up to about 95 vol%, hence providing achieving high heat dissipation.

The heat conductivity of insulating board 106 is not less than 2 W/m·K. Heat sink 110 provided on bottom surface 106B of insulating board 106 releases, through insulating board 106, heat that is not released from heat emitting layer 108. This prevents the temperature of top surface 106A of insulating board 106 more effectively from rising.

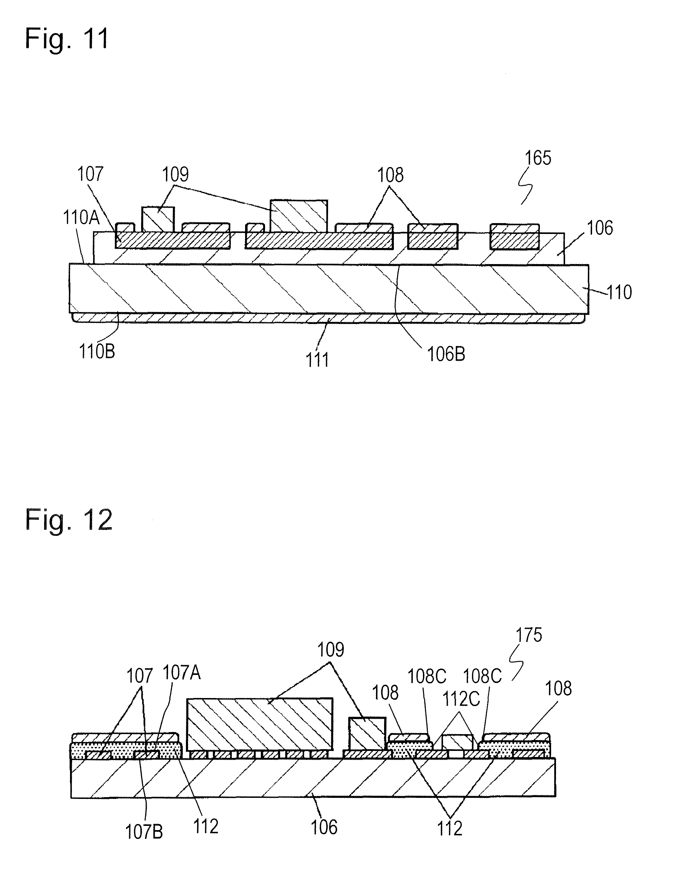

Fig. 11 is a sectional view of another wiring board 165 according to Embodiment 7. In Fig. 11, components identical to those of wiring board 155 shown in Fig. 10 are denoted by the same reference numerals, and their description will be omitted.

Wiring board 165 further includes heat emitting layer 111 provided on bottom surface 110B of heat sink 110 of wiring board 155 shown in Fig. 10. If insulating board 106 has a relatively high heat conductivity, heat emitting layer 111 provided on bottom surface 110B of heat sink 110 effectively emits heat from wiring board 165 (insulating board 106).

A heat emitting area is increased to increase heat dissipation. Thus, heat emitting layers 108 and 111 are roughened to release heat efficiently.

According to Embodiment 7, conductor pattern 107 is embedded in insulating board 106. However, conductor pattern 107 may be stuck onto insulating board 106 with an adhesive. Conductor pattern 107 may not necessarily form a circuit, but may be a conductor just for emitting heat.

Wiring board 165 provides the same effects as wiring board 105 according to Embodiment 6.

EXEMPLARY EMBODIMENT 8

Fig. 12 is a sectional view of wiring board 175 according to Exemplary Embodiment 8. In Fig. 12, components identical to those of wiring board 105 according to Embodiment 6 shown in Fig. 9 are denoted by the same reference numerals, and their description will be omitted.

Wiring board 175 further includes resin layer 112 provided between top surface 106A of insulating board 106 and heat emitting layer 108 of wiring board 105 according to Embodiment 6 shown in Fig. 9. Resin layer 112 is provided on conductor pattern 107 and on top surface 106A of insulating board 106. Heat emitting layer 108 is provided on resin layer 112. Resin layer 112 prevents solder from unnecessarily spreading on wiring board 175 (insulating board 106) when implementing electronic component 109 on wiring board 175 (insulating board 106), which means resin layer 112 functions as a solder resist. Resin layer 112 and heat emitting layer 108 cover substantially entirely top surface 106A and conductor pattern 107 having electronic component 109 mounted thereto except respective portions of conductor pattern 107 and top surface 106A facing electronic component 109 and except a portion soldered to electronic component 109. Heat emitting layer 108 is located directly above top surface 107A of conductor pattern 107. In wiring board 175 according to Embodiment 8, heat emitting layer 108 faces top surface 107A of conductor pattern 107 across resin layer 112, and is located away from conductor pattern 107, i.e., do not contact conductor pattern 107.

Resin layer 112 allows heat emitting layer 108 to be formed on substantially entirely top surface 106A of insulating board 106 while maintaining electrical insulation between conductor patterns 107. This allows heat emitting layer 108 easily formed even if conductor pattern 107 is extremely fine.

Resin layer 112, an insulator, is formed below heat emitting layer 108, and allows heat emitting layer 108 to contain 40 vol% or more of N-type semiconductor particles mixed therein, thus increasing heat dissipation from the surface of wiring board 105.

In wiring board 175, in the case that heat emitting layer 108 contains a high content of N-type semiconductor particles, outer periphery 108C of heat emitting layer 108 is preferably located slightly inward from outer periphery 112C of resin layer 112 to increase electrical insulation between conductor patterns 107.

Wiring board 175 provides the same effects as wiring board 105 according to Embodiment 6.

In wiring boards 105, 155, 165, and 175 according to Embodiments 6 to 8, heat from electronic component 109 can be released as light energy. Thus, a semiconductor having operation efficiency reduced and breaking due to heat can be mounted as electronic component 109 to insulating board 106.

In all the embodiments, terms, such as "top surface", "bottom surface", and "directly above" indicate just a relative direction of a component, such as the insulating board, the conductor pattern, and the heat emitting layer, and do not indicate an absolute direction, such as a vertical direction.

INDUSTRIAL APPLICABILITY

A wiring board according to the present invention suppresses the temperature rise of an electronic component, allowing the electronic component which malfunctions or breaks due to the heat to be mounted thereto.

## Claims

1. A wiring board arranged to have an electronic component mounted thereto, said wiring board comprising:

   an insulating board having a top surface and a bottom surface opposite to the top surface, the top surface arranged to have the electronic component mounted thereto;
   a conductor pattern formed on the top surface of the insulating board, the conductor pattern being arranged to be connected to the electronic component; and
   a first heat emitting layer made of first heat-emitting material covering the conductor pattern,

   wherein the first heat-emitting material has an emissivity not less than 0.8 for an electromagnetic wave having a wavelength $\lambda = 0.002898/T$ at a temperature $T$ ranging from 293K to 473K.

2. The wiring board of claim 1, further comprising a resin layer provided on the conductor pattern, wherein the first heat emitting layer is provided on the resin layer, and the resin layer has a reflectivity not higher than 10% for an electromagnetic wave having a wavelength ranging from $6.1\mu m$ to $9.9\mu m$.

3. The wiring board of claim 1, wherein the first heat emitting layer is provided on the conductor pattern.

4. The wiring board of claim 3, wherein the first heat emitting layer is provided partially on the conductor pattern.

5. The wiring board of claim 3, wherein the first heat emitting layer is located also on the top surface of the insulating board.

6. The wiring board of claim 1, wherein the first heat emitting layer also covers the top surface of the insulating resin.

7. The wiring board of claim 1, wherein an average emissivity of the first heat-emitting material for an electromagnetic wave having a wavelength ranging from $9.0\mu m$ to $9.5\mu m$ is higher than an average emissivity of the first heat-emitting material for an electromagnetic wave having a wavelength ranging from $6.5\mu m$ to $7.0\mu m$.

8. The wiring board of claim 1, further comprising a second heat emitting layer made of second heat-emitting material provided on the bottom surface of the insulating board, wherein the second heat-emitting material has an emissivity not less than 0.8 for an electromagnetic wave having a wavelength $\lambda = 0.002898/T$ at temperature $T$ ranging from 293K to 473K, and an average emissivity of the second heat-emitting material for an electromagnetic wave having a wavelength ranging from $9.0\mu m$ to $9.5\mu m$ is higher than an average emissivity of the first heat-emitting material for an electromagnetic wave having a wavelength ranging that between $9.0\mu m$ to $9.5\mu m$.

9. The wiring board of claim 8, further comprising a third heat emitting layer made of third heat-emitting material arranged to be provided on a surface of the electronic component, wherein an emissivity of the third hear-emitting material for an electromagnetic wave having a wavelength $\lambda = 0.002898/T$ at temperature $T$ ranging from 293K to 473K.

10. The wiring board of claim 1, wherein the first heat-emitting material contains one of insulating particles and semiconductor particles, the one of the insulating particles and the semiconductor particles having an emissivity not less than 0.9 doe an electromagnetic wave having a wavelength $\lambda = 0.002898/T$ at a temperature $T$ of the first heat-emitting material ranging from 293K to 473K.

11. The wiring board of claim 1, wherein the conductor pattern is embedded in the top surface of the insulating board such that the conductor is exposed at the top surface of the insulating board.

12. The wiring board of claim 1, further comprising a second heat emitting layer made of second heat-emitting material arranged to be provided on a surface of the electronic component, wherein the second heat-emitting material has an emissivity not less than 0.8 for an electromagnetic wave having a wavelength $\lambda = 0.002898/T$ at a temperature $T$ of the second heat-emitting material ranging from 293K to 473K.

13. A wiring board arranged to have an electronic component mounted thereto, said wiring board comprising:

    an insulating board having a top surface and a bottom surface opposite to the top surface, the top surface being arranged to have the electronic component mounted thereto;
    a conductor pattern provided on the top surface of the insulating board, the conductor patter being arranged to be connected to the electronic component; and
    a heat emitting layer covering the conductor pattern, the heat emitting layer containing 5.0 vol% or more of N-type semiconductor particles.

14. The wiring board of claim 13, wherein the heat emitting layer contains 5.0 vol% to 95 vol% of the N-type semiconductor particles.

15. The wiring board of claim 13, further comprising a resin layer provided on the conductor pattern, wherein the heat emitting layer is provided on the resin layer.

16. The wiring board of claim 13, wherein the heat emitting layer is provided on the conductor pattern.

17. The wiring board of claim 16, wherein the heat emitting layer is provided partially on the conductor pattern.

18. The wiring board of claim 16, wherein the heat emitting layer is also provided on the top surface of the insulating board.

19. The wiring board of claim 18, wherein the heat emitting layer contains 5.0 vol% to 40 vol% of N-type semiconductor particles.

20. The wiring board of claim 13, wherein the heat emitting layer also covers the top surface of the insulating resin.

21. The wiring board of claim 13, wherein the conductor pattern is embedded in the top surface of the insulating board such that the conductor pattern is exposed at the top surface of the insulating board.

22. The wiring board of claim 13, wherein the N-type semiconductor particles have an average particle diameter ranging from 0.1μm to 20μm.

# Fig. 1

# Fig. 2

Fig. 3

Fig. 4

Fig. 5

Fig. 6

Fig. 7

Fig. 8

## Fig. 9

## Fig. 10

Fig. 11

Fig. 12

Fig. 13

## INTERNATIONAL SEARCH REPORT

| | International application No. |
| --- | --- |
| | PCT/JP2008/000727 |

A.  CLASSIFICATION OF SUBJECT MATTER
*H05K1/02*(2006.01)i, *H05K7/20*(2006.01)i

According to International Patent Classification (IPC) or to both national classification and IPC

B.  FIELDS SEARCHED

Minimum documentation searched (classification system followed by classification symbols)
H05K1/02, H05K7/20, H01L23/34-23/473

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y | JP 2004-336020 A  (Oki Electric Industry Co., Ltd.),<br>25 November, 2004 (25.11.04),<br>Par. Nos. [0012] to [0029]; Fig. 1<br>& US 2004/207075 A1    & CN 1571148 A | 1,3-6,10-14,<br>16-22 |
| Y | JP 2004-158706 A  (Nippon Steel Corp.),<br>03 June, 2004 (03.06.04),<br>Claims 1, 2; Par. Nos. [0008] to [0017],<br>[0022], [0023]; Figs. 1, 2<br>(Family: none) | 1,3-6,10-14,<br>16-22 |
| Y | JP 2006-283092 A  (JFE Steel Corp.),<br>19 October, 2006 (19.10.06),<br>Par. No. [0019]<br>(Family: none) | 13,14,16-22 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    08 May, 2008 (08.05.08) | Date of mailing of the international search report<br>    20 May, 2008 (20.05.08) |
| --- | --- |
| Name and mailing address of the ISA/<br>    Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/000727

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-356436 A  (Fujitsu Hitachi Plasma Display Ltd.), 16 December, 2004 (16.12.04), Par. Nos. [0054], [0055], [0077] to [0092]; Figs. 15, 20 to 27 (Family: none) | 1-22 |
| A | JP 2004-211060 A  (Ceramission Co., Ltd.), 29 July, 2004 (29.07.04), Par. Nos. [0026], [0060]; Fig. 3 & US 2004/147656 A1      & CN 1508172 A | 1-22 |
| A | JP 2005-228860 A  (Oki Electric Industry Co., Ltd.), 25 August, 2005 (25.08.05), Full text; all drawings & US 2005/178574 A1      & CN 1655348 A | 1-22 |
| A | JP 2005-123317 A  (Ceramission Co., Ltd.), 12 May, 2005 (12.05.05), Full text; all drawings (Family: none) | 1-22 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007035716 A
- JP 2005252144 A